# EUROPEAN PATENT SPECIFICATION

(11) **EP 1 624 471 B1**
(45) Date of publication and mention of the grant of the patent: **20.01.2010**
(21) Application number: 05254435.0
(22) Date of filing: 15.07.2005
(51) Int. Cl.: H01G 4/008, H01G 9/042, B05D 3/06, H01L 21/265

(54) **Method for making an electrode by ion beam implantation**
Verfahren zur Herstellung einer Elektrode durch Ionenstrahlimplantation
Méthode pour fabriquer une électrode par implantation avec faisceau d'ions

(30) Priority: 16.07.2004 US 892279
(43) Date of publication of application: 08.02.2006
(73) Proprietor: Greatbatch Ltd., Clarence, NY 14031 (US)
(72) Inventor: Muffoletto, Barry, Alden NY 14004 (US); Shah, Ashish, East Armherst NY 14051 (US)
(74) Representative: Duckett, Anthony Joseph

(56) References cited:
- WO-A-03/056585
- US-A1- 2003 207 134
- US-B1- 6 281 080
- PATENT ABSTRACTS OF JAPAN vol. 1995, no. 10, 30 November 1995 (1995-11-30) -& JP 07 169656 A (MITSUBISHI ALUM CO LTD), 4 July 1995 (1995-07-04)
- PATENT ABSTRACTS OF JAPAN vol. 1996, no. 05, 31 May 1996 (1996-05-31) -& JP 08 003673 A (MITSUBISHI ALUM CO LTD), 9 January 1996 (1996-01-09)

## Description

### 1. Field of the Invention

This invention relates to the art of treating metals, metal alloys and metal oxides, and more particularly to a new and improved method for enhancing the electrical conductivity of metals, metal alloys and metal oxides.

One area of use of the present invention is in the manufacturing of electrodes for capacitors, batteries and the like, although the principles of the present invention can be variously applied. Metals and metal alloys have a native oxide present on the surface. This is an insulating layer and, hence, if the material is to be used as a substrate for an electrode, the oxide has to be removed or made electrically conductive.

If the oxide is removed by chemical treatment, such as by etching with an acid or electrolytic etching to expose the underlying metal, special steps must be taken in order to complete the electrical contacts before the native oxide can be regenerated and interfere with the electrical contacts. Such measures require special apparatus and extremely careful handling of the materials. All of this adds cost to fabrication of these materials into electrical devices to which electrical contact must be made.

Another approach involves removing the oxide layer and plating the bare substrate metal with an expensive noble metal, such as silver, gold, or alloys of silver, gold and platinum, or the formation of an electrically conducting compound on the bare substrate surface. The overcoating materials are expensive and the steps required to plate the substrate are costly and time consuming. In addition, the metal plating or electrically conductive compound must be disposed on the substrate as a continuous film for maximum performance. Therefore, the plating or compound formation typically is carried out after the substrate metal is formed into its final shape for the intended electrical device in order to avoid damage to the coating. This, in turn, adds to the cost and complexity of the manufacturing process.

### 2. Prior Art

U. S. Patent No. 5,098,485 to Evans proposes a solution to the oxide problem by altering the native oxide from an electrically insulating to an electrically conducting condition. This is done without removal of the native oxide layer to expose the underlying metal or alloy. A solution containing ions of an electrical material is applied to the native oxide layer, and then the substrate, oxide and applied ions are heated to an elevated temperature for a time sufficient to incorporate the ions into the oxide layer, changing it from an electrical insulator to an electrical conductor.

U.S. Patent No. 5,599,580 to Muffoletto et al. relates to a method for improving the electrical conductivity of a substrate by depositing a small amount of metal thereon and then directing a high-energy beam onto the substrate. This intermixes the deposited material with the native oxide of the metal substrate, changing the native oxide from being electrically insulating to electrically conductive. The high-energy beam is an ion beam from a high-energy ion source or a laser beam. The substrate with the electrically conductive native oxide layer is useable in the manufacture of electrodes for capacitors and batteries.

### SUMMARY OF THE INVENTION

It would, however, be highly desirable to provide a new and improved method for enhancing the electrical conductivity of metals, metal alloys and metal oxides that does not require additional heat treatment, provides control over the density and depth of the material introduced to the treated surface, can be performed in a manner preventing substrate degradation and deformation, and improves the quality of the treated surface.

The present invention which is defined by the features of claim 1, provides such a method for improving the electrical conductivity of a substrate of a metal, metal alloy or metal oxide by doping the native oxide with a suitable material causing the oxide to become electrically conductivity. This is done with ions embedded into the metal, metal alloy and/or metal oxide causing the oxide layer to become electrically conductive. The method can be used for metal, metal alloys and/or oxide and mixed oxides from Groups IVA, (Ti, Zr, and Hf), VA, (V, Nb, and Ta), VIA, (Cr, Mo, and W), Al, Mn, Ni, and Cu). The ions or mixtures of ions to be implanted are from Group VIIIA metals (Fe, Ru, Os, Co, Rh, Ir, Ni, Pd, and Pt) elements. These ions are implanted using an ion implantation process. This includes elements from Group VIIIA being in the form of charged, energetic particles that are directed into the substrate metal, metal alloy and/or oxide from Groups IVA, VA, and VIA. The doped ions reside in the substrate as impurities.

The method of the present invention advantageously provides a doping method that does not require additional heat treatment and also provides control over the dose and depth of the ions implanted in the treated surface. The method can be performed at low temperatures preventing substrate degradation and deformation. It is believed that the quality of the treated surface is improved by the method of the present invention. An additional advantage of the present invention is that the surface can be treated to passivate it from chemical reaction while still providing adequate electrical conductivity. Stainless steels having native insulating oxides can also be treated to provide an electrically conductive oxide layer.

A substrate treated by the method of the present invention is ready for further processing in the manufacture of an electrode for use in a capacitor, a battery, and the like. Typically, in the case of a capacitor, an appropriate electrode material is deposited on the treated substrate surface by techniques well known to those skilled in the art. Examples of electrode materials are redox pseudo capacitance materials such as, but not limited to, oxides and mixed oxides of ruthenium, iridium, manganese, nickel, cobalt, tungsten, niobium, iron, molybdenum or under potential deposition systems such as palladium, platinum, lead dioxide or electro-active conducting polymers such as polyaniline, polypyrole and polythiophene.

The foregoing and additional advantages and characterizing features of the present invention will become clearly apparent upon a reading of the ensuing detailed description together with the included drawings wherein:

### BRIEF DESCRIPTION OF THE DRAWINGS

FIG. 1 is a diagrammatic view illustrating a substrate having a native oxide layer that is treated by the method of the present invention.
FIG. 2 is aschematic view of an ion beam implanter 18 useful in carrying out the process of the invention.
FIG. 3 is a diagrammatic view of a substrate after treatment by the method of the present invention.
FIG. 4 is a diagrammatic view of the substrate of FIG. 3 having electrode material deposited thereon for use in manufacture of a capacitor electrode.
FIGs. 5, 6 and 7 are graphs depicting impedance spectroscopy scans on substrates of the type shown in FIG. 4.

### DETAILED DESCRIPTION OF THE PREFERRED EMBODIMENTS

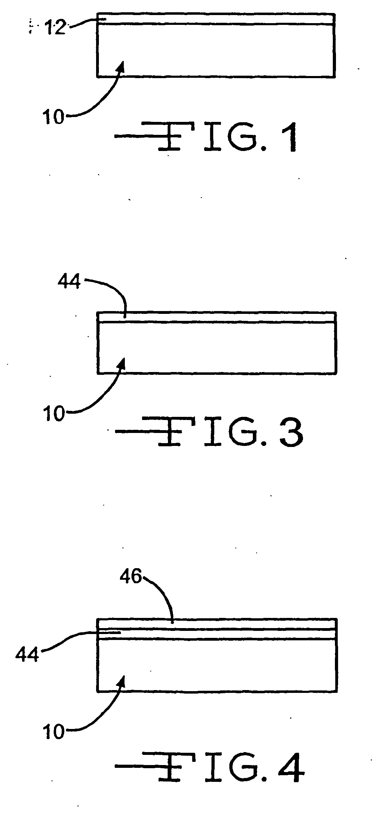

Metals and metal alloys have a native oxide present on the surface that is electrically insulating and must be removed or made electrically conductive if the metal or metal alloy is to be used as an electrode in devices such as capacitors and batteries. Referring to FIG. 1, there is shown a substrate 10 having an electrically insulating native oxide layer 12 on a surface thereof. In accordance with the present invention, oxide layer 12 is made more electrically conductive, i.e. changed from electrically insulating to electrically conductive. Substrates treated by the method of the present invention include metals and alloys thereof selected from the groups consisting of Group IVA metals (Ti, Zr, and Hf), Group VA metals (V, Nb, and Ta), Group VIA metals (Cr, Mo, and W), aluminum, manganese, nickel, copper and stainless steel. They typically have a thickness in the range from about 0.001 mm. to about 2.0 mm.

In accordance with the present invention, the-native oxide layer 12 is doped with a suitable material causing it to become electrically conductive. Doping is by ions embedded therein. The ions or mixtures of ions to be implanted are from Group VIIIA (Fe, Ru, Os, Co, Rh, Ir, Ni, Pd, and Pt) elements. These ions are implanted using an ion implantation process such as those used in the manufacture of semiconductors. In this process, elements from Group VIIIA in the form of charged, energetic particles are directed into the above substrate metals, metal alloys and/or oxides as impurities.

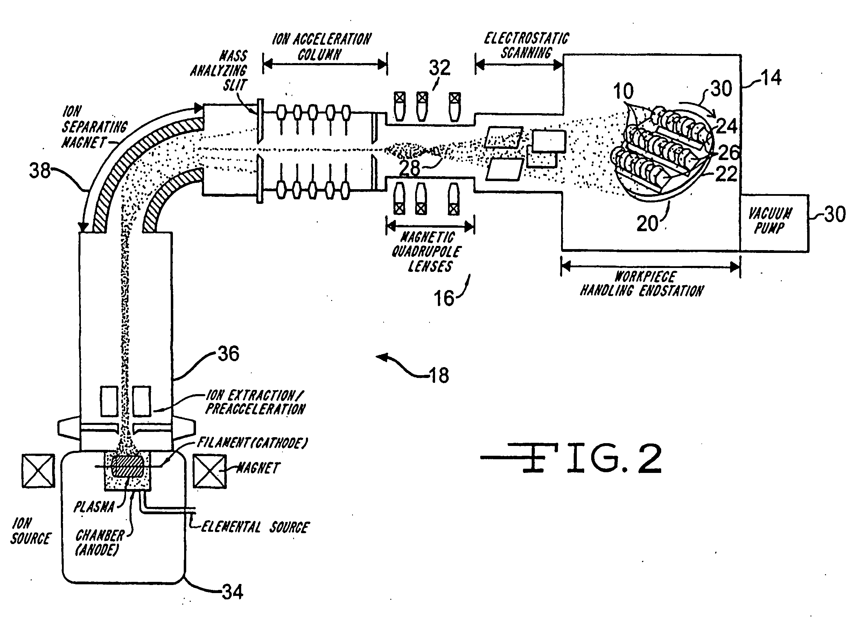

Referring to FIG. 2, the doping process is preferably carried out in a suitable doping or implantation chamber 14 of a specially designed end station 16 of a suitable high current ion generating apparatus 18, such as a Varian-Extrion 200 kV implanter, an Eaton-Nova implanter, and a like instrument. A fixture 20 supported on a base 22 is mounted within the implantation chamber 14. The base 22 is designed to rotate and cool a base plate 22, such as of titanium. A plurality of appropriately shaped substrate holders 26, also made of titanium, is mounted on the base plate 24. The holders 26 are designed to securely hold a plurality of substrates 10 and directly expose them to an incoming ion beam 28. It is to be understood that the shape of the particular substrate holders secured to the base plate 24 depends upon the shape of the particular substrate being worked on. Also, the holders 26 have been conditioned so that they do not give off ions during ion implantation into the native oxide 12 on the substrates. If this were to happen and the holders were of a different material than that of the intended doping ions, the native oxide 12 would be contaminated by an unintended material, which could affect its conductivity.

The substrates 10 first are introduced into the implantation chamber 14 and held by the holders 26 supported on the base plate 26 of the base 22 of the fixture 20. The next step involves the creation of a proper vacuum environment within the implantation chamber 14. To this end, a vacuum within the implantation chamber 14 must be created which is less than about 5 x 10⁻⁴ torr, and preferably is about 1 x 10⁻⁷ torr. After a plurality of substrates 10 is introduced into the chamber 14, the proper vacuum is established therein 14 by vacuum pump 30. Preferably, the vacuum pump 30 should be of an oil-free type so as to avoid the possibility of introducing surface contamination onto the part to be ion implanted.

With the substrates 10 secured in the fixtures 20 within the implantation chamber 14, the outer surfaces containing the native oxide layer 12 are exposed to a direct line of the incoming ion beam 28. In order to achieve such a direct line, the fixture 20 is rotatable on its base 22 by motors (not shown), as indicated by an arrow 32. The ion beam 28 is of at least one of the elemental doping materials that have been introduced into an ion production chamber 34. The thusly-created ions pass through an ion extraction pre-accelerator 36, then to separating magnets 38 before traveling through an ion accelerator 40. Careful attention must be paid to having the proper ion beam power density acting on the surfaces of the substrates 10. For, if it is too high in certain areas, localized heating may occur. Consequently, the peak ion beam power density of a 50 keV beam should not exceed about ten microamperes per square centimeter.

Control of the ion beam power density can be achieved in a number of ways. Preferably, and as herein illustrated, this low power ion beam current density is affected by expanding the spot size of the incoming ion beam 28 by a magnetic Quadra pole or an electro-static lens system 42. The surfaces of the substrates 10, now secured in the fixture 20 within the implant chamber 14, are then exposed to the incoming ion beam 28, properly modified, if need be, by the lens system 42, for a period from about one minute to about one hour, and preferably for about five to ten minutes. A preferred ion beam particle energy is about 50 keV, and implants a dose of about 1 x 10¹⁴ ions/cm² to about 1 x 10²¹ ions/cm², preferably about 3 x 10¹⁷ ions/cm², to a depth of about 100 to 10,000 angstroms, preferably about 200 angstroms, below the outer surfaces of the substrates 10.

The result is that the ion implanted native oxide 12 surface of each substrate 10 has had its properties modified, i.e., rendered electrically conductive, without leaving any discrete layer on its surface. Since the ion implantation process is typically carried out at room temperature, it does not create toxic or hazardous waste, and is readily compatible with clean room and high technology processing environments.

Doping by means of the ion implantation method of the present invention converts the electrically insulating native oxide layer 12 to a doped layer 44 on substrate 10, as shown in Fig. 3. This doped layer 44 has a degree of electrical conductivity sufficient to render the substrate 10 useable as an electrode in a device such as a capacitor or battery. In other words, native oxide layer 12 has been converted from being essentially non-conductive, i.e. insulating, to having an increased and improved degree of electrical conductivity. Thus, the quality of the treated surface of substrate 10 is improved in that the surface layer 12 is changed from an insulating, semiconducting or dielectric state to a doped, electrically conducting state 44.

The substrate shown in FIG. 3, treated by the method of the present invention, is ready for further processing in the manufacture of an electrode for use in capacitors, batteries and the like. Typically, in the case of a capacitor, an appropriate electrode material 46, as shown in FIG. 4, is deposited on the substrate treated surface by techniques well known to those skilled in the art. Examples of electrode material 46 are redox pseudo capacitance materials such as, but not limited to, oxides and mixed oxides of ruthenium, iridium, manganese, nickel, cobalt, tungsten, niobium, iron, molybdenum, or under potential deposition systems such as palladium, platinum, lead dioxide or electro-active conducting polymers such as polyaniline, polypyrole, and polythiophene.

The present invention is illustrated further by the following examples.

### EXAMPLE I

A tantalum substrate similar to substrate 10 shown in FIG. 1 was abraded on one side using a 3M Scotch-brite pad of a very fine type. This produced a rough surface on the side to be coated. It was then degreased and cleaned. This was accomplished by cleaning the foil in an ultrasonic bath using acetone as a solvent for about 10 minutes. Next, the substrate was washed in an ultrasonic methanol bath and then blow-dried, using dry, clean compressed air.

The substrate was now ready to have the native oxide layer at its outer surface doped with palladium. This was done by first loading the substrate into an ion beam generating apparatus evacuated to a pressure of about 1 x 10⁻⁵ torr. Palladium ions were introduced into the ion production chamber. Then, an energetic ion beam of Pd ions with an energy level of about 50 keV bombarded the deposited surface causing the palladium to mix with the substrate. This continues until the palladium ions had penetrated to a depth of about 200 angstroms at a concentration of about 3 x 10¹⁷ ions/cm². On completion, the substrate surface was ready to be coated with ruthenium oxide for use in making a capacitor electrode.

### COMPARATIVE EXAMPLE I

A tantalum substrate was prepared according to the previously discussed U.S. Patent No. 5,098,485 to Evans. In particular, a brush made from palladium wires was brought into contact with and brushed across a dry tantalum surface. It is believed that palladium atoms were thereby mechanically transferred to the tantalum and tantalum oxide. The brushed tantalum was heated to 900°C for 15 minutes, producing an electrically conductive surface that was then coated with ruthenium oxide in a similar manner as in Example I.

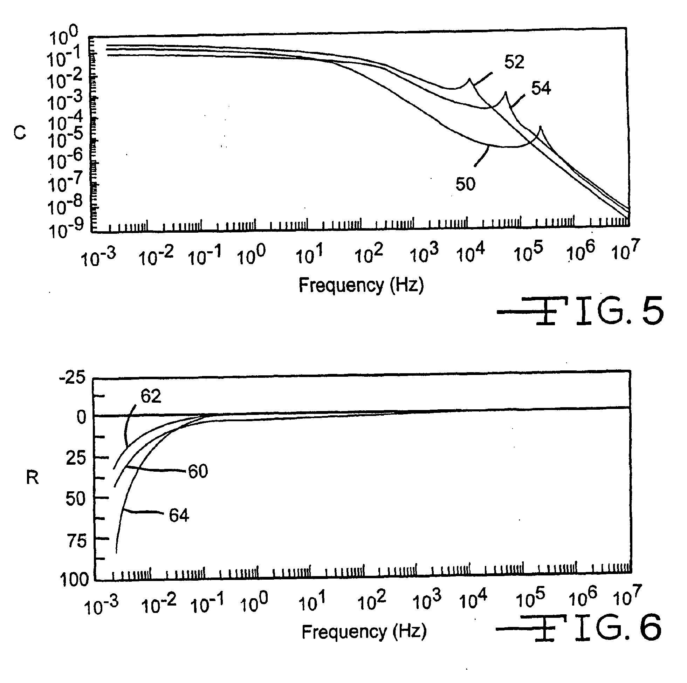

FIG. 5 compares the capacitance of ruthenium oxide coating a bare tantalum substrate to the capacitance of ruthenium oxide coating tantalum treated according to Example I and Comparative Example I. Curve 50 in FIG. 5 is for bare or unprocessed tantalum. Curves 52 and 54 are for tantalum treated according to the present invention (Example I) and according to the prior art Evans patent (Comparative Example I), respectively.

FIG. 6 compares the resistance of ruthenium oxide coating a bare tantalum substrate to the resistance of ruthenium oxide coating tantalum treated according to Example I and Comparative Example I. Curve 60 in FIG. 6 is for bare or unprocessed tantalum. Curves 62 and 64 are for tantalum treated according to the present invention (Example I) and according to the prior art Evans patent (Comparative Example I), respectively. The relatively lower capacitance and higher resistance of the untreated tantalum (curves 50 and 60) is due to the presence of the insulating native oxide. The prior art treatment according to the Evans patent (curves 54 and 64), while an improvement over an untreated substrate, does not render the native oxide as electrically conductive as the present invention doping technique (curves 52 and 62).

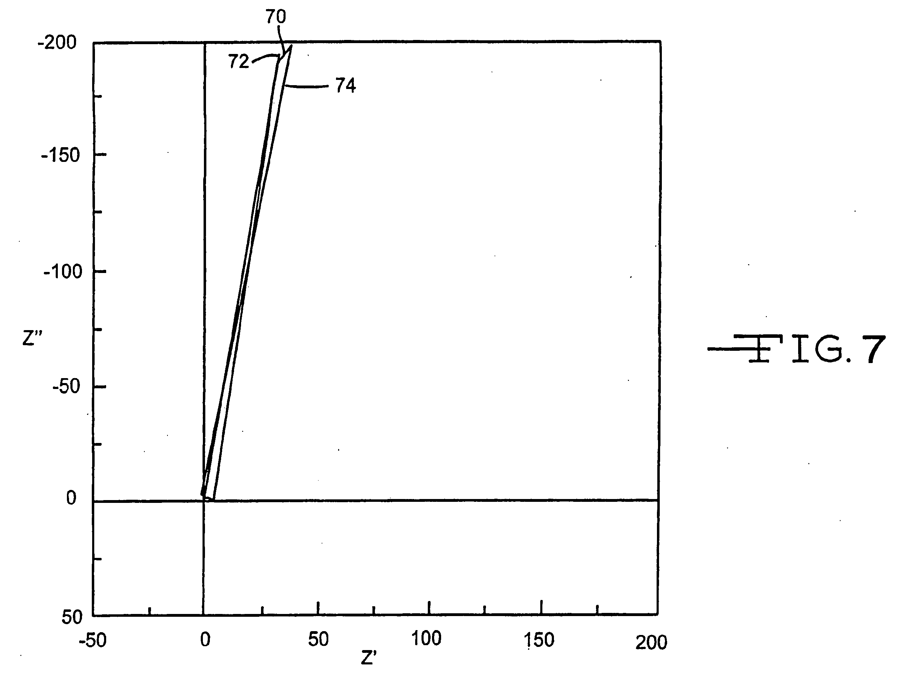

FIG. 7 shows the coating behavior of unprocessed tantalum in curve 70, and processed tantalum where doping is by way of ion beam in curve 72 according to the present invention of Example I and where doping is by way of the treatment technique of the Evans patent in curve 74 according to Comparative Example I. The curves of FIG. 7 also were obtained by performing impedance spectroscopy scans on the electrodes. They show the same results as the curves of FIGS. 5 and 6, but from a different perspective. They show the relative ideal behavior of the electrodes when used as capacitors. An ideal capacitor has no resistance and the spectroscopy scan would be a vertical line, perpendicular to the horizontal. Consequently, the closer the scan is to vertical, the more ideal the capacitor, or in this case the electrode. The scan for ruthenium oxide coating on unprocessed tantalum, shown by curve 70 in FIG. 7, is the farthest away from the vertical and, thus, is less ideal than the coatings on processed tantalum.

It is therefore apparent that the present invention accomplishes its intended objects. While embodiments of the present invention have been described in detail, that is for the purpose of illustration, not limitation.

## Claims

1. A method for making an electrode, which method comprises the steps of:
a) providing a substrate having an electrically insulating native oxide layer on a surface thereof, wherein the substrate is selected from the group consisting of Group IVA, Group VA, and Group VIA metals, aluminium, manganese, nickel, copper, and stainless steel;
b) directing a high energy beam of doping ions onto the native oxide layer to intermix the doping ions with the native oxide;
c) whereby the native oxide layer is changed from being electrically insulating to being more electrically conductive; and
d) applying an electrode material onto the doped native oxide layer so that the substrate is usable as an electrode.

2. The method of Claim 1 wherein the substrate is a material useful as an electrode in a capacitor.

3. The method of Claim 1 or Claim 2 which includes selecting the doping ions from the group consisting of Fe, Ru, Os, Co, Rh, Ir, Ni, Pd, Pt and mixtures thereof.

4. The method of any one of the preceding claims wherein the high-energy beam comprises an ion beam.

5. The method of any one of the preceding claims which includes directing the ion beam at the native oxide layer in a raster-like pattern.

6. The method of any one of the preceding claims which includes controlling the depth of intermixing of the doping ions into the native oxide so as not to affect the bulk structure of the substrate.

7. The method of any one of the preceding claims which includes intermixing the doping ions with the native oxide to a depth of 10nm to 1000nm (100 angstroms to 10,000 angstroms).

8. The method of any one of the preceding claims wherein the electrode material is a capacitor electrode material.

9. The method of any one of the preceding claims which includes providing the doping ions at a concentration of 1 x 10¹⁴ ions/cm² to 1 x 10²¹ ions/cm² in the native oxide layer.

10. The method of any one of the preceding claims which includes directing the high energy beam of doping ions onto the native oxide layer in a vacuum of 5 x 10⁻⁴ torr to 1 x 10⁻⁷ torr.

11. Use of a high energy beam of doping ions directed onto a native oxide layer on a metal substrate to intermix the doping ions with the native oxide thereby increasing the electrical conductivity thereof for making an electrode according to the method of any of claims 1 to 10.

12. Use according to Claim 11 wherein the doping ions are selected from the group consisting of Fe, Ru, Os, Co, Rh, Ir, Ni, Pd, Pt and mixtures thereof.

## Patentansprüche

1. Verfahren zur Herstellung einer Elektrode mit den folgenden Schritten:
a) Zurverfügungstellen eines Substrates mit einer elektrisch isolierenden, nativen Oxidschicht auf einer seiner Oberflächen, wobei das Substrat aus der Gruppe ausgewählt wird, die aus Metallen der Gruppe IVA, Gruppe VA und Gruppe VIA, Aluminium, Mangan, Nickel, Kupfer und rostfreiem Stahl besteht;
b) Richten eines Hochenergie-Strahls von Dotierungs-Ionen auf die native Oxidschicht, um die Dotierungs-Ionen mit dem nativen Oxid zu mischen,
c) wodurch die native Oxidschicht aus dem elektrisch isolierenden Zustand zu einem mehr elektrisch leitenden Zustand geändert wird; und
d) Aufbringen eines Elektrodenmaterials auf die dosierte native Oxidschicht, so dass das Substrat als Elektrode nutzbar ist.

2. Verfahren nach Anspruch 1, wobei das Substrat ein Material ist, das als Elektrode in einem Kondensator nutzbar ist.

3. Verfahren nach einem der Ansprüche 1 oder 2, das die Auswahl der Dotierungs-Ionen aus der Gruppe umfasst, die aus Fe, Ru, Os, Co, Rh, Ir, Ni, Pd, Pt und Gemischen davon besteht.

4. Verfahren nach einem der vorhergehenden Ansprüche, wobei der Hochenergie-Strahl einen Ionen-Strahl umfasst.

5. Verfahren nach einem der vorhergehenden Ansprüche, das die Richtung des Ionen-Strahls auf die native Oxidschicht in einem rasterähnlichen Muster umfasst.

6. Verfahren nach einem der vorhergehenden Ansprüche, das die Steuerung der Tiefe des Vermischens der Dotierungs-Ionen in das native Oxid umfasst, um den Großteil der Sruktur des Substrats nicht zu beeinflussen.

7. Verfahren nach einem der vorhergehenden Ansprüche, das die Vermischung der Dotierungs-Ionen mit dem nativen Oxid bis zu einer Tiefe von 10 nm bis 100 nm (100 Angström bis 10.000 Angström) umfasst.

8. Verfahren nach einem der vorhergehenden Ansprüche, wobei das Elektrodenmaterial ein Kondensator-Elektrodenmaterial ist.

9. Verfahren nach einem der vorhergehenden Ansprüche, das die Zurverfügungstellung der Dotierungs-Ionen mit einer Konzentration von 1 x 10¹⁴ Ionen/cm² bis 1 x 10²¹ Ionen/cm² in der nativen Oxidschicht umfasst.

10. Verfahren nach einem der vorhergehenden Ansprüche, das die Richtung des Hochenergie-Strahls der Dotierungs-Ionen auf die native Oxidschicht in einem Vakuum von 5 x 10⁻⁴ Torr bis 1 x 10⁻⁷ Torr umfasst.

11. Verwendung eines Hochenergie-Strahls von Dotierungs-Ionen, die auf eine native Oxidschicht auf einem Metallsubstrat gerichtet werden, um die Dotierungs-Ionen mit dem nativen Oxid zu vermischen, wodurch seine elektrische Leitfähigkeit erhöht wird, zur Herstellung einer Elektrode gemäß dem Verfahren nach einem der Ansprüche 1 bis 10.

12. Verwendung nach Anspruch 11, wobei die Dotierungs-Ionen aus der Gruppe ausgewählt werden, die aus Fe, Ru, Os, Co, Rh, Ir, Ni, Pd, Pt und ihren Gemischen besteht.

## Revendications

1. Procédé pour fabriquer une électrode, ledit procédé comprenant les étapes consistant à :
a) fournir un substrat ayant une couche d'oxyde natif isolante électriquement sur une surface de celui-ci, le substrat étant sélectionné parmi le groupe composé de métaux du Groupe IVA, du Groupe VA, et du Groupe VIA, d'aluminium, de manganèse, de nickel, de cuivre et d'acier inoxydable ;
b) diriger un faisceau de grande énergie d'ions de dopage sur la couche d'oxyde natif pour mélanger les ions de dopage avec l'oxyde natif ;
c) ce que la couche d'oxyde natif soit ainsi modifiée, d'un état d'isolation électrique à un état davantage conducteur d'électricité ; et
d) appliquer un matériau d'électrode sur la couche d'oxyde natif dopé de telle sorte que le substrat soit utilisable en tant qu'électrode.

2. Procédé selon la revendication 1, dans lequel le substrat est un matériau utile en tant qu'électrode dans un condensateur.

3. Procédé selon la revendication 1 ou la revendication 2, comprenant la sélection des ions de dopage parmi le groupe composé de Fe, Ru, Os, Co, Rh, Ir, Ni, Pd, Pt et de mélanges de ceux-ci.

4. Procédé selon l'une quelconque des revendications précédentes, dans lequel le faisceau de grande énergie comprend un faisceau d'ions.

5. Procédé selon l'une quelconque des revendications précédentes, comprenant la direction du faisceau d'ions sur la couche d'oxyde natif selon un agencement de type trame.

6. Procédé selon l'une quelconque des revendications précédentes, comprenant le contrôle de la profondeur du mélange des ions de dopage dans l'oxyde natif de façon à ne pas affecter la structure de la masse du substrat.

7. Procédé selon l'une quelconque des revendications précédentes, comprenant le mélange des ions de dopage avec l'oxyde natif à une profondeur de 10 nm à 1 000 nm (100 angströms à 10 000 angströms).

8. Procédé selon l'une quelconque des revendications précédentes, dans lequel le matériau d'électrode est un matériau d'électrode de condensateur.

9. Procédé selon l'une quelconque des revendications précédentes, comprenant la fourniture des ions de dopage à une concentration de 1 x 10¹⁴ ions/cm² à 1 x 10²¹ ions/cm² dans la couche d'oxyde natif.

10. Procédé selon l'une quelconque des revendications précédentes, comprenant la direction du faisceau de grande énergie des ions de dopage sur la couche d'oxyde natif dans un vide de 5 x 10⁻⁴ torr à 1 x 10⁻⁷ torr.

11. Utilisation d'un faisceau de grande énergie d'ions de dopage dirigé sur une couche d'oxyde natif sur un substrat métallique pour mélanger les ions de dopage avec l'oxyde natif, augmentant ainsi la conductivité électrique de celui-ci pour fabriquer une électrode selon le procédé selon l'une quelconque des revendications 1 à 10.

12. Utilisation selon la revendication 11, dans laquelle les ions de dopage sont sélectionnés parmi le groupe composé de Fe, Ru, Os, Co, Rh, Ir, Ni, Pd, Pt et de mélanges de ceux-ci.
